# FASCICULE DE BREVET EUROPEEN

(11) **EP 2 121 186 B1**
(45) Date de publication et mention de la délivrance du brevet: **30.10.2019**
(21) Numéro de dépôt: 08775628.4
(22) Date de dépôt: 05.03.2008
(51) Int. Cl.: B01L 3/00, C30B 7/00, C30B 7/08, G01N 35/08, C30B 29/58

(54) **PROCEDE DE SUIVI DE LA CRISTALLISATION D'UNE SUBSTANCE**
VERFAHREN ZUR NACHVERFOLGUNG DER KRISTALLISIERUNG EINES STOFFES
METHOD FOR FOLLOWING UP THE CRYSTALLISATION OF A SUBSTANCE

(30) Priorité: 05.03.2007 US 905022 P
(43) Date de publication de la demande: 25.11.2009
(73) Titulaire: Rhodia Opérations, 93306 Aubervilliers (FR); Centre National de la Recherche Scientifique (C.N.R.S.), 75016 Paris (FR)
(72) Inventeur: JOANICOT, Mathieu, F-92290 Chatenay-malabry (FR); LAVAL, Philippe, F-75011 Paris (FR); LENG, Jacques, F-33000 Bordeaux (FR); SALMON, Jean-Baptiste, F-33800 Bordeaux (FR)
(74) Mandataire: Lavoix
(86) Numéro de dépôt international: PCT/FR2008/000288
(87) Numéro de publication internationale: WO 2008/132309

(56) Documents cités:
- EP-A2- 1 574 586
- WO-A1-2008/046989
- WO-A2-2007/030501
- FR-A- 2 907 228
- US-A1- 2005 129 580
- US-A1- 2005 129 580
- US-A1- 2006 003 439
- US-A1- 2006 137 597
- US-A1- 2007 052 781

## Description

La présente invention concerne un procédé et un dispositif microfluidique de suivi de la cristallisation d'une substance, ainsi qu'un procédé de criblage comprenant un tel procédé de suivi.

L'invention vise plus particulièrement, mais non exclusivement, l'étude du polymorphisme, à savoir la possibilité que présente une molécule donnée de cristalliser dans différentes structures cristallines, sans toutefois changer de composition chimique. Les différentes formes cristallines qu'est susceptible d'adopter cette molécule sont dénommées polymorphes.

Le fait de prédire quel polymorphe est susceptible de cristalliser est d'une grande importance pour les procédés chimiques et pharmaceutiques, dans la mesure où chaque polymorphe d'une substance donnée présente des propriétés physiques spécifiques. On se référera aux publications suivantes : J. Bernstein, J. Phys. D. Appl. Phys. 26,66 (1993) ; K. Sato, J. Phys D. Appl. Phys. 26,77 (1993) ; J. Bernstein, J. Davey, and J. O. Henck, Angew. Chem. Int. Ed. 88,3440 (1999).

Cependant, l'état de la technique ne permet pas d'accéder à une compréhension complète de la complexité du processus de cristallisation en solution. Une telle insuffisance est en particulier due aux liens existant entre les caractéristiques thermodynamiques des diagrammes de phases et la cinétique des transitions de phases (en particulier de la nucléation), aux difficultés expérimentales pour obtenir des mesures fiables et reproductibles, du fait de la présence des impuretés, ainsi qu'au grand nombre de paramètres, tels que le pH, la température ou la présence de solvant, qui jouent un rôle notable. Pour illustrer ce dernier point, on se référera aux publications suivantes : J. W. Mullin, Crystallisation (Butterworth-Heinemann, Oxford, 2001); A. C. Zettlemoyer, Nucleation (Marcel Dekker, New-York, 1969); N. Rodriguez-Hornedo and D. Murphy, Journal of Pharmaceutical Sciences 88,651 (1999) ; D. Kashchiev, D. Clausse, and C. Jolivet-Dalmazzone, J. Colloid Interface Sci. 165,148 (1994).

Les techniques à haut débit sont susceptibles d'améliorer cette compréhension, en apportant des possibilités de plus grand criblage des conditions de cristallisation. De plus, la microfluidique apparaît une bonne passerelle pour de telles expériences, dans la mesure où elle offre un contrôle très précis, par la conception de trajectoires cinétiques spécifiques dans des diagrammes de phases. Sur ce dernier aspect, on se référera aux publications suivantes : C. L. Hansen, S. Classen, J. M. Berger, and S. R. Quake, J. Am. Chem. Soc. 128,3142 (2006) ; J. Leng, B. Lonetti, P. Tabeling, M. Joanicot, and A. Ajdari, Phys. Rev. Lett. 96,084503 (2006) ; C. J. Gerdts V. Tereshko, M. K. Yadav, I. Dementieva, F. Collart, A. Joachimiak, R. C. Stevens, P. Kuhn, A. Kossiakoff, and R. F. Ismagilov, Angew. Chem. Int. Ed Engl, 45,8156 (2006).

De plus, la microfluidique offre une possibilité de cribler un très grand nombre de systèmes physico-chimiques en utilisant de très faibles quantités de composés, variant typiquement dans la gamme du nanolitre (nL) au microlitre (µL). Sur ce dernier point, à savoir la technologie du « Lab on chip », on se référera aux publications suivantes : C. L. Hansen, E. Skordalakee, J. M. Berger, and S. R. Quake, Proc. Natl. Acad. Sci. USA 99,16531 (2002) ; D. L. Chen and R. F. Ismagilov, Current Opinion in Chemical Biology 10,226 (2006) ; K. Shinohara, T. Fukui, H. Abe, N. Sekimura, and K. Okamoto, Langmuir 22,6477 (2006) ; B. Zheng, J. D. Tica, L. S. Roach, and R. F. Ismagilov, Angew. Chem. Int. Ed. 43,2508 (2004). D'autre part US 2005/129580 présente un procédé de cristallisation d'une substance en solution dans un solvant et de son suivi, dans un microcanal par microscopie et fluorescence.

Ceci étant précisé, l'invention vise à metre en oeuvre un procédé permettant d'accéder, de façon plus précise que dans l'art antérieur, à la compréhension des phénomènes de cristallisation.

A cet effet, elle a pour objet un procédé de suivi de la cristallisation d'une substance en solution dans un solvant, comprenant les étapes suivantes :
- on forme des gouttes de ladite solution, éventuellement à différentes concentrations de ladite substance, dans une phase inerte ;
- on produit et on stocke les gouttes dans au moins un microcanal de stockage ;
- on forme des cristaux dans toutes les gouttes en refroidissant ces gouttes au-dessous de la température de solubilité de ladite substance :
   - on augmente la température afin d'induire la dissolution d'au moins une partie des cristaux dans au moins certaines gouttes ;
   - on observe le processus de cristallisation et de dissolution par l'intermédiaire de moyens d'analyse.

L'invention a également pour objet un procédé de suivi de la cristallisation d'une substance en solution dans un solvant, comprenant les étapes suivantes :
- on forme des gouttes de la solution, éventuellement à différentes concentrations de la substance, dans une phase inerte ;
- on produit et on stocke les gouttes dans au moins un microcanal de stockage ;
- on forme des cristaux dans toutes les gouttes, le volume de chaque goutte étant suffisamment petit pour induire un mécanisme de cristallisation mononucléaire, dans au moins une majorité des gouttes ; et
- on observe au moins deux structures cristallines différentes pour la même substance, dans au moins deux gouttes distinctes.

L'invention peut comprendre au moins certaines des caractéristiques suivantes, compatible(s) avec l'une ou l'autre des définitions données ci-dessus :
- on forme les gouttes à une température supérieure à la solubilité de ladite substance ;
- on forme des cristaux dans toutes les gouttes en refroidissant ces gouttes au-dessous de la température de solubilité ;
- les moyens d'analyse comprennent la spectroscopie Raman ou la microscopie optique ;
- le procédé selon l'invention, comprend une étape supplémentaire d'observation de la structure des cristaux formés pendant la cristallisation, notamment par spectroscopie Raman ;
- le procédé selon l'invention, comprend l'observation d'au moins deux structures cristallines différentes pour la même substance, en vue de la détermination du polymorphisme ;
- on forme au moins cent gouttes, de préférence au moins deux cent gouttes ;
- le volume de chaque goutte formée est suffisamment petit pour induire un mécanisme de cristallisation mononucléaire, dans au moins une majorité des gouttes ;
- le volume de chaque goutte formée est inférieur à 1 µL, de préférence inférieur à 0,2 µL ;
- la phase inerte est une huile silicone ou une huile fluorée ;
- on mesure la solubilité en fonction de la température d'un polymorphe métastable ou de plusieurs polymorphes en même temps ;
- on abaisse et/ou on monte la température des gouttes selon des paliers ;
- la différence de température par palier est comprise entre 0,1 et 5 degrés, de préférence entre 0,5 et 1 degré ;
- le nombre de paliers est compris entre 10 et 50, notamment entre 20 et 30 ;
- on identifie une première température, pour laquelle tous les cristaux sont formés ;
- on fait descendre la température par paliers, on dénombre les cristaux pour différentes valeurs de température, et on détermine ladite première température comme étant la température au-dessous de laquelle aucun cristal supplémentaire n'est formé ;
- on identifie une seconde température, pour laquelle tous les cristaux sont dissous ;
- on augmente la température par paliers, on dénombre les cristaux pour des valeurs de température de plus en plus élevées, et on identifie ladite seconde température comme étant la température au-dessus de laquelle aucun cristal supplémentaire n'est dissous.

Est aussi décrit ici un dispositif microfluidique pour le suivi de la cristallisation d'une substance en solution dans un solvant, comprenant :
- au moins un microcanal de stockage de gouttes de ladite solution dans une phase inerte ;
- une première entrée permettant d'introduire ladite solution dans ledit microcanal de stockage ;
- une seconde entrée permettant d'introduire ladite phase inerte dans ledit microcanal de stockage ;
- des moyens permettant de fermer ledit microcanal de stockage, qui sont agencés en aval de ce microcanal de stockage.

Selon d'autres caractéristiques du dit dispositif :
- le dispositif comprend en outre des moyens permettant de chauffer et de refroidir les gouttes stockées dans le microcanal de stockage ;
- le microcanal de stockage a un diamètre équivalent compris entre 50 µm et 1 mm, de préférence entre 400 et 600 µm ;
- le microcanal de stockage est formé dans un matériau choisi parmi les matériaux élastomères, tel qu'une silicone, plus particulièrement telle que le PDMS, le verre, le silicium, le PMMA, des résines photosensibles ;
- les moyens permettant de chauffer et de refroidir les gouttes comprennent un module de type Peltier ;
- le dispositif comprend en outre une entrée supplémentaire permettant d'introduire une quantité supplémentaire de iadite phase inerte ou d'une seconde phase inerte, qui n'est pas miscible avec ladite phase inerte, afin d'espacer les gouttes et d'éviter leur coalescence ;
- le dispositif comprend en outre une sortie agencée entre les première et seconde entrées et le microcanal de stockage ;
- le dispositif comprend en outre une autre entrée supplémentaire, permettant d'introduire une quantité supplémentaire de la phase solvant de la solution dans le microcanal de stockage, cette autre entrée supplémentaire étant située entre les première et seconde entrées et le microcanal de stockage.

L'invention a enfin pour objet un procédé de criblage de plusieurs substances, dans lequel on prépare lesdites plusieurs substances, on réalise un suivi de la cristallisation de chaque substance selon le procédé tel que défini ci-dessus, et on identifie au moins une substance préférée, parmi lesdites plusieurs substances.

Selon d'autres caractéristiques de l'invention :
- on prépare lesdites plusieurs substances en modifiant au moins un paramètre de ces substances, choisi notamment parmi le pH, la présence d'impuretés, ou encore la présence d'au moins un adjuvant ;
- lesdites plusieurs substances sont formées d'un mélange d'au moins deux composants, et on prépare lesdites substances différentes en modifiant la proportion de ces composants.

L'invention va être décrite ci-après, en référence aux dessins annexés, donnés uniquement à titre d'exemple non limitatif, dans lesquels :
- la figure 1 est une vue de face, illustrant un dispositif d'écoulement appartenant à une installation ;
- la figure 2 est une vue en perspective, illustrant l'installation
- la figure 3 est une vue de face, à plus grande échelle que la figure 1, illustrant la formation de gouttes ;
- la figure 4 est un graphe, illustrant une descente de température d'une solution, opérée selon un procédé conforme à l'invention ;
- la figure 5 est un graphe, illustrant le nombre de cristaux présents, en fonction de la température, pour différentes concentrations de la solution ;
- la figure 6 est un graphe, analogue à la figure 4, illustrant une remontée en température de la solution, opérée conformément à l'invention ;
- la figure 7 est un graphe, illustrant différentes courbes de solubilité de la solution ;
- les figures 8 et 9 sont des graphes, illustrant les spectres Raman de deux cristaux différents, isolés grâce à l'invention ;
- la figure 10 est une vue de face, à plus grande échelle que la figure 1.

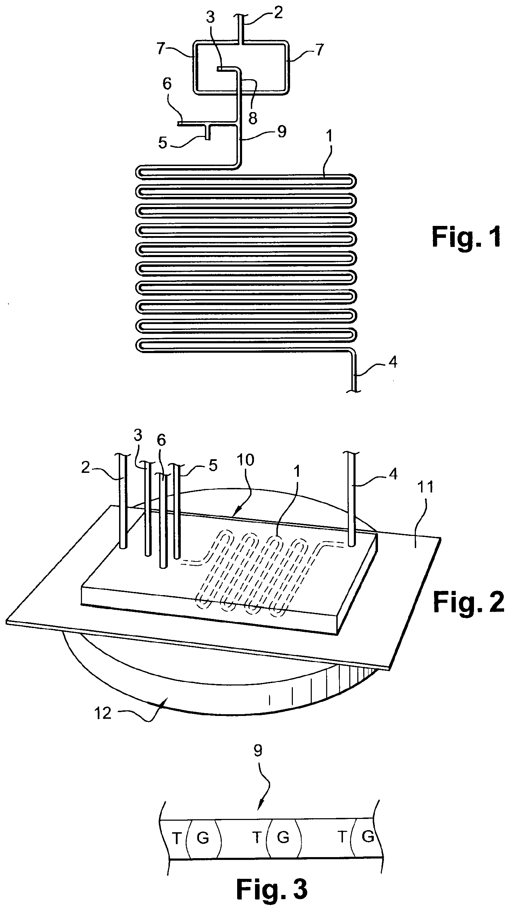

Le dispositif de stockage illustré sur les figures 1 et 2, comprend tout d'abord au moins un microcanal 1, destiné à stocker une succession de gouttes comme on le verra dans ce qui suit. Ce microcanal 1 est par exemple gravé dans une plaquette 10, visible plus particulièrement sur la figure 2, selon des procédures classiques de l'état de la technique. A ce sujet, on se référera notamment à la publication « D. C. Dussy, J. C. Macdonald, Olivier J. A. Schueller, Georges M. Whitesides, Anna L. Chem., 70, P. 4974-4984, 1998 ».

Les matériaux constitutifs de cette plaquette sont par exemple choisis parmi le verre, qui est un matériau préféré, ou encore les matériaux élastomères, tels que les silicones. On peut également utiliser des plaquettes de PDMS (Poly-(diméthylsiloxane)), de silicium, de PMMA (Polyméthyl Méthacrylate), ou encore des résines photosensibles. Le microcanal peut être de toute forme appropriée, par exemple de section circulaire ou transversale. La dimension transversale, tel que le diamètre dans le cas d'un microcanal circulaire, est comprise avantageusement entre 50 µm et 1 mm, de préférence entre 400 et 600 µm.

Le dispositif de stockage comprend en outre une entrée 2 permettant d'introduire une phase inerte dans le microcanal 1, ainsi qu'une entrée 3 permettant d'introduire, dans ce microcanal, la solution dont on désire étudier la cristallisation. L'entrée 2 est associée à deux microcanaux 7 formant, de manière connue, un motif carré, qui se rejoignent au niveau de leur intersection avec un microcanal supplémentaire 8, mis en communication avec l'entrée 3. Ainsi, après cette intersection, ces différents microcanaux 7 et 8 débouchent dans un microcanal 9, dit de liaison, qui est lui-même mis en communication avec l'entrée du microcanal de stockage 1.

De plus, à l'extrémité du microcanal 1 opposée aux entrées 2 et 3, il est prévu des moyens 4 permettant de fermer ce microcanal de stockage 1, à savoir de stopper l'avancée de la solution au sein de ce microcanal 1. De tels moyens de fermeture sont par exemple formés par une vanne, de tout type approprié.

Enfin, il est prévu une entrée supplémentaire 5, permettant d'introduire une quantité supplémentaire de phase inerte, ou bien une seconde phase inerte de nature différente qui n'est pas miscible avec la première phase inerte. Comme on le verra dans ce qui suit, ceci permet d'espacer le cas échéant les gouttes et ainsi d'empêcher leur coalescence. Cette entrée supplémentaire 5 est associée avec une sortie 6, qui sont toutes deux mises en communication avec le microcanal de liaison 9.

Comme le montre la figure 2, les différents microcanaux sont obturés par l'intermédiaire d'une plaque 11, de manière connue en soi. Cette plaque 11, qui est par exemple en silicium, est associée à des moyens permettant de chauffer et de refroidir les gouttes stockées dans le microcanal 1. Ces moyens de variation de la température comprennent par exemple un module Peltier, de type connu en soi. Ce module est illustré de manière schématique sur la figure 2, où il est affecté de la référence 12.

Chacune des entrées 2, 3 et 5, ainsi que la sortie 6, sont propres à recevoir une extrémité d'un tube, dont l'autre extrémité est reliée à une seringue. Le débit de chaque composant administré est contrôlé par l'intermédiaire d'un pousse-seringue. Ces tubes, ces seringues et ces pousse-seringues sont bien connus de l'état de la technique, de sorte qu'ils ne serons pas décrits plus en détail dans ce qui suit.

L'installation comprend en outre des moyens d'observation d'au moins une partie du microcanal de stockage 1. Ces moyens, non représentés, sont par exemple formés par un microscope. De plus, il est prévu des moyens d'analyse des gouttes contenues dans le microcanal de stockage. De tels moyens d'analyse sont par exemple formés par un spectromètre de type Raman, également non représenté.

Conformément à l'invention, il s'agit d'étudier une solution qui comprend un solvant, ainsi qu'une substance susceptible de cristalliser sous différentes formes, à savoir de générer des polymorphes. A titre d'exemple, cette solution peut être formée par du nitrate de potassium (KNO₃), dans de l'eau.

Chaque polymorphe est associée à une température de solubilité correspondante. On note Tₘᵢₙ la température dite minimale, au-dessous de laquelle toutes les formes polymorphes sont cristallisées, ainsi que Tₘₐₓ la température dite maximale au-dessus de laquelle toutes les formes polymorphes sont dissoutes.

On forme tout d'abord des gouttes de cette solution dans une phase inerte. A cet effet, on introduit la solution par l'entrée 2, et la phase inerte, qui est par exemple de l'huile de silicone, par l'entrée 3. En aval de l'intersection, à savoir dans le microcanal de liaison 9, il se forme de manière connue en soi un train de gouttes G, séparées par des tronçons T de phase porteuse (voir figure 3). De façon avantageuse, le volume de chaque goutte G est inférieur à 1 µL, de préférence inférieur à 0.2 µL. Comme on le verra plus en détail dans ce qui suit, ce faible volume permet d'induire un mécanisme de cristallisation mononucléaire dans la majorité des gouttes.

Après leur formation, décrite ci-dessus, les gouttes sont introduites dans le microcanal de stockage 1, à une température supérieure à la température Tₘₐₓ évoquée ci-dessus. De la sorte, l'ensemble des produits sont sous forme soluble, de sorte qu'il n'existe pas de risque d'obstruction du microcanal. Il est à noter que cette valeur Tₘₐₓ est, éventuellement, connue pour la valeur de concentration relative à la solution injectée initialement. En revanche, cette valeur de température peut ne pas être connue pour d'autres gammes de concentrations.

Puis, lorsqu'un nombre suffisant de gouttes est présent dans le microcanal 1, en particulier lorsque l'ensemble de celui-ci est occupé par les gouttes, on ferme la vanne 4. Dans ces conditions, le train de gouttes est immobilisé au sein du microcanal de stockage 1. De façon avantageuse, au moins cent gouttes, de préférence au moins deux cent gouttes sont présentes dans ce microcanal de stockage 1. Pour atteindre un tel nombre, il est possible d'ajuster la taille des gouttes et/ou la longueur du microcanal d'écoulement. La présence d'un nombre de gouttes élevé est avantageuse, car cela permet de visualiser un grand nombre de polymorphes éventuels.

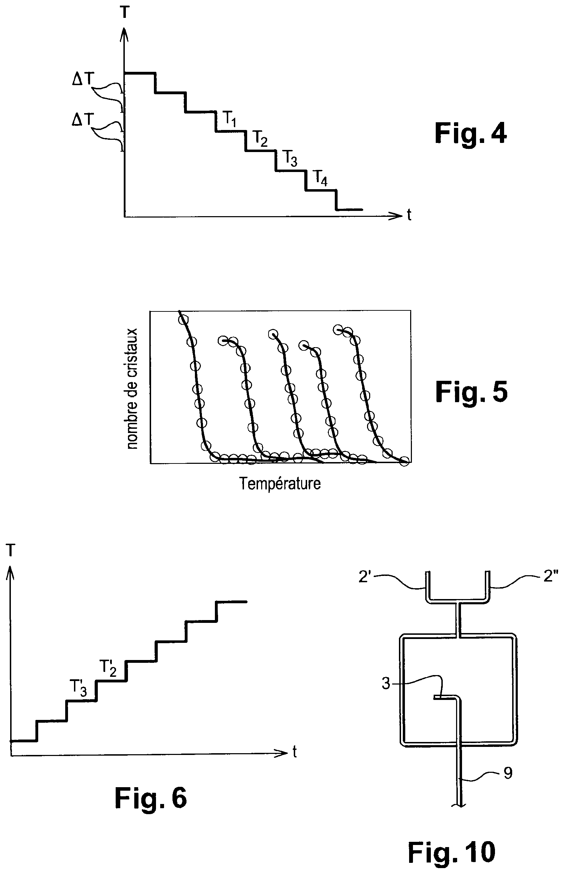

Ensuite, il s'agit de former des cristaux dans l'ensemble des gouttes. A cet effet, grâce au module Peltier, on abaisse progressivement la température, jusqu'à une valeur située au-dessous de la valeur Tₘᵢₙ évoquée ci-dessus. Cette descente en température est opérée par gradins, comme cela est illustré à la figure 4.

Ce profil de descente de température peut être décrit au moyen de deux caractéristiques principales :
- la valeur de chaque gradin, à savoir la chute de température *Δ*T opérée au niveau de chaque gradin ; et
- le nombre total N de gradins.

De façon avantageuse, *Δ*T est compris entre 0,1 et 5 degrés, de préférence entre 0,5 et 1 dégré, alors que le nombre N de gradins est compris entre 10 et 50, de préférence entre 20 et 30. On notera que, sur les figures 4 et 6, on a illustré un nombre bien inférieur de gradins, afin de ne pas surcharger les dessins. Au fur et à mesure de la descente de température, on observe la présence éventuelle de cristaux dans la substance et, dans l'affirmative, on estime le nombre de ces cristaux.

Ainsi, en référence à la figure 4, on observe la substance étudiée pour quatre valeurs de température, notées T₁ à T₄. On constate l'apparition des premiers cristaux à T₁, la présence d'un nombre plus important à T₂, puis d'un nombre beaucoup plus élevé de cristaux à T₃. Enfin, à T₄, on constate que le nombre de cristaux n'a sensiblement pas augmenté, par rapport à la température T₃. Dans ces conditions, on peut en conclure que T₃ correspond à la température Tₘᵢₙ évoquée ci-dessus.

Il est également possible de tracer une courbe, illustrant le nombre de cristaux présents en fonction de la température. Plusieurs courbes analogues peuvent être tracées, pour différentes concentrations. La figure 5 illustre cinq de ces courbes, notées C₁ à C₅, pour différentes valeurs de concentration. Pour chacune de ces courbes, au fur et à mesure que la température augmente, on constate que le nombre de cristaux présents est tout d'abord très élevé, puis diminue très brusquement, avant de se stabiliser à une valeur nulle. On constate également que, plus la concentration est élevée, plus les cristaux apparaissent à une température basse.

On descend alors jusqu'à une valeur de température inférieure de deux à trois degrés par exemple à celle de Tₘᵢₙ, déterminée ci-dessus, de sorte qu'on s'assure que toutes les gouttes sont cristallisées. Il s'agit alors au contraire d'augmenter la température, selon le profil illustré à la figure 6. Comme pour la descente de température, cette montée s'opère par gradins, dont la valeur et le nombre sont par exemple identiques à ceux de la phase de descente.

Lors de cette remontée en température, on procède à différentes observations des gouttes, afin d'identifier l'éventuelle dissolution des cristaux initialement formés et, dans l'affirmative, évaluer le nombre de ces cristaux dissous. Ainsi, à une température notée T'₃, on constate que seulement une partie des cristaux sont dissous.

En revanche, à une température plus haute, notée T'₂, des cristaux supplémentaires ont été dissous, à partir de cette température intermédiaire T'₃. Ceci permet de conclure à la présence de deux types de cristaux différents, associés à des températures de dissolution différentes. On notera que les valeurs T'₃ et T'₂, correspondant à la montée en température, sont différentes de celles T₂ et T₃ relatives à la descente de température illustrée à la figure 4.

Enfin, si l'on continue à élever la température au-dessus de T'₂, on observe une dissolution de tous les cristaux à la température Tₘₐₓ, telle que définie ci-dessus. Ainsi, on notera que cette remontée en température permet de vérifier la valeur de cette température Tₘₐₓ, si elle est déjà connue, ou encore de déterminer cette valeur si elle est inconnue, par exemple dans le cas où on fait varier la concentration.

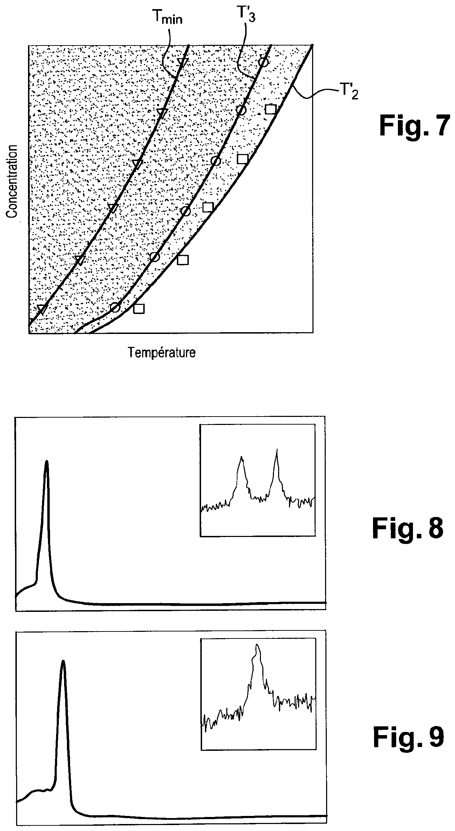

La figure 7 illustre les variations, en fonction de la concentration c, des températures Tₘᵢₙ, T'₃ et T'₂. Tₘᵢₙ correspond à l'estimation de la limite de métastabilité du système pour des petits volumes de réacteurs, tels que les gouttes utilisées dans l'invention. Cette valeur Tₘᵢₙ est d'une importance notable pour l'optimisation d'un processus de cristallisation, en termes notamment de morphologie, de taille, ainsi que de distribution de taille.

La variation de T'₂ en fonction de la concentration correspond à la courbe de solubilité du nitrate de potassium, telle que donnée dans la littérature (voir D. R. Lide, Handbook of chemistry and physics (CRC Press, 2004-2005)). Cependant, la présence d'une courbe T'₃ en fonction de la concentration indique la présence d'un polymorphe métastable, dont la solubilité est plus élevée que l'état stable d'une température donnée. Il s'agit par conséquent d'un système monotropique et concomitant, au sens de celui donné dans J. Bernstein, J. Davey, and J. O. Henck, Angew. Chem. Int. Ed. 88,3440 (1999).

Afin de confirmer que ces deux formes identifiées présentent effectivement des structures cristallines distinctes, on a réalisé des mesures spectroscopiques sur les cristaux, directement à l'intérieur des gouttes. A cet effet, on peut utiliser un microscope Raman de type Lab Ram HR/JOBIN-YVON, dont la longueur d'onde d'excitation est de 532 nm et l'objectif est de 10 x. Les courbes des figures 8 et 9 correspondent respectivement aux températures T'₂ et T'₃.

Les valeurs des fréquences vibratoires des modes covalents V₁, V₃ de NO₃⁻ permettent d'identifier la forme, qui dissout à la température T'₂, comme la forme stable de KNO₃, à savoir l'état II. De plus, la forme qui dissout à T'₃ correspond au polymorphe ferroélectrique, dénommé état III. Sur ce dernier point, on se référera aux publications suivantes: Frankenheim, Ann. Physik 40,447 (1837) ; F. C. Kracek, J. Phys. Chem. 34,225 (1930) ; J. K. Nimmo and B. W. Lucas, Acta Cryst. B32,1968 (1976) ; C. N. R. Rao, B. Praskash, and M. Natarajan, Nat. Stand. Ref. Data. Ser., U.S. Nat. Bur. Stand. 53,1 (1975).

L'état III est connu pour apparaître lorsque des cycles de température spécifiques sont réalisés à la pression atmosphérique, sur des cristaux simples de KNO₃. Sur ce point, on se référera aux publications suivantes : M. Balkanski, M. K. Teng, and M. Nusimovici, Phys. Rev. 176,1098 (1968) ; M. H. Brooker, J. Phys. Chem. Solids 39,657 (1978) ; R. Murugan, P. J. Huang, A. Ghule, and H. Chang, Thermochimica Acta. 346,83 (2000).

Ainsi, lorsque les cristaux stables sont chauffés au-dessus de 130°C, ils subissent tout d'abord une transformation vers une structure rhomboédrique (état I). Ensuite, ils se transforment en état III sous refroidissement, qui semble stable dans la gamme de 110 à 120°C, avant de retrouver à nouveau l'état II à des températures basses. Tout ceci indique que la transition entre l'état III et l'état II se produit sur une large gamme de températures, ce qui signifie que l'état III peut être détecté comme un état métastable à la température ambiante. L'invention permet ainsi d'observer la nucléation en solution de cette forme métastable.

Comme cela ressort de ce qui précède, l'invention permet d'accéder à des mesures de la courbe de solubilité de polymorphes métastables, tels que l'état III de KNO₃ en solution. Or, la solubilité de ce type de polymorphes ne peut en général être caractérisée, en utilisant les procédés de l'art antérieur.

Sans vouloir être lié par la théorie, on suppose que cette possibilité d'accès à des états métastables est en particulier permise par le fait que, dans les gouttes utilisées, il ne se produit sensiblement pas de nucléation multiple. En d'autres termes, le mécanisme de cristallisation est mononucléaire, à savoir qu'il implique un unique phénomène de nucléation.

Dans ces conditions, quand bien même un polymorphe est métastable, il ne se transforme pas ensuite vers un état plus stable. Or, les procédés de l'art antérieur s'accompagnent en général d'une telle nucléation multiple, de sorte que le polymorphe métastable ne peut être étudié, dans la mesure où il se transforme en un polymorphe plus stable, immédiatement après son apparition. En d'autres termes, dans l'état de la technique, les polymorphes métastables présentent une durée de vie extrêmement faible, de sorte qu'ils ne peuvent être étudiés.

A cet égard, on notera que le fait d'utiliser des gouttes de faible volume est avantageux, afin d'éviter toute nucléation multiple. De plus, le fait d'utiliser des gouttes, séparées par des tronçons de phase inerte, permet d'éviter d'éventuelles interactions entre les différents cristaux. On notera également que l'invention évite de faire appel à une agitation, susceptible d'induire des nucléations multiples.

Enfin, conformément à l'invention, de nombreux cristaux individuels sont étudiés, ce qui permet de révéler de façon efficace les différentes solubilités, dans le cas de l'existence de polymorphes différents. De plus, les moyens de variation de température utilisés dans l'invention permettent de fixer cette température de manière fiable et homogène, ce qui assure la distinction entre des polymorphes dont les solubilités sont proches les unes des autres.

Un autre mode de réalisation de l'invention est illustré en référence à la figure 10. Dans ce mode de réalisation, on réalise un procédé de criblage de différentes substances.

A cet effet, il s'agit tout d'abord de préparer ces différentes substances. Ainsi, l'entrée unique 2 est remplacée, dans l'exemple illustré, par deux entrées 2' et 2", au niveau de chacune desquelles on admet un composant. La substance qu'on désire étudier est par conséquent formée par le mélange de ces deux composants.

On prépare une première substance, que l'on étudie conformément au procédé décrit ci-dessus. Puis, on modifié au moins un paramètre, afin de modifier la composition de cette substance. A titre d'exemple non limitatif, ces paramètres sont notamment la concentration de chaque composant au sein de la substance, le pH, ou encore la présence éventuelle d'impuretés. Après avoir étudié les différentes substances, ainsi préparées, on détermine une ou plusieurs substances préférées, en fonction notamment de l'application visée.

Selon une variante non représentée, on peut former chaque substance à partir d'au moins trois composants. Dans ces conditions, il est prévu un nombre correspondant d'entrées, analogues à celles 2' et 2".

L'invention n'est pas limitée aux exemples décrits et représentés.

Ainsi, dans l'exemple de réalisation ci-dessus, la descente et la montée en température s'opèrent selon des profils respectifs en forme de gradins. Cependant, on peut prévoir de procéder à une baisse et/ou à une montée de température présentant des profils différents, tels que notamment : profil en gradin unique, profil continûment croissant ou décroissant, descentes et remontées successives en température.

Selon une autre caractéristique de l'invention, il est possible de procéder uniquement à une phase de cristallisation, sans dissolution postérieure. Dans ces conditions, au cours de cette cristallisation, qui s'opère notamment par descente de température, selon l'une ou l'autre des variantes présentées ci-dessus, on forme des cristaux, un unique cristal étant présent par goutte, pour une majorité des gouttes. A cette fin, on réalise des gouttes de très faible volume, comme indiqué ci-dessus. Puis, une fois ces cristaux formés, on identifie les polymorphes éventuels.

Ainsi, dans cette dernière variante de réalisation, présentée immédiatement ci-dessus, l'invention a pour objet un procédé de suivi de la cristallisation d'une substance en solution dans un solvant, comprenant les étapes suivantes :
- on forme des gouttes de la solution, éventuellement à différentes concentrations de la substance, dans une phase inerte ;
- on produit et on stocke les gouttes dans au moins un microcanal de stockage ;
- on forme des cristaux dans toutes les gouttes, le volume de chaque goutte étant suffisamment petit pour induire un mécanisme de cristallisation mononucléaire, dans au moins une majorité des gouttes ; et
- on observe au moins deux structures cristallines différentes pour la même substance, dans au moins deux gouttes distinctes.

Les caractéristiques ci-dessus peuvent être combinées avec toute autre caractéristique, décrite dans la présente demande, qui soit techniquement compatible.

Un exemple de réalisation de l'invention va être donné dans ce qui suit, à titre purement non limitatif.

Le dispositif microfluidique, tel que décrit aux figures 1 et 2, est fabriqué en PDMS en utilisant les techniques standards de lithographie, telles que décrites dans J. C. Mcdonald and G. M. Whitesides, Accounts of chemical research 35,491 (2002). La hauteur et la largeur des canaux est de 500 µm. Le dispositif en PDMS est scellé par l'intermédiaire d'une plaque en silicium, afin d'augmenter les transferts thermiques.

La phase inerte (huile de silicone, Rhodorsil 20 CST) et la solution aqueuse (KNO₃, Normapur Merck dans de l'eau déionisée) sont injectées à des débits contrôlés, en utilisant des pousse-seringues. Des gouttes aqueuses monodisperses sont formées dans le microcanal de liaison 9. Des débits typiques de 1800 et 600 µL par heure, respectivement pour la phase inerte et la phase aqueuse, produisent des gouttes dans la gamme de 100 à 200 nanolitres. Une phase inerte supplémentaire peut également être injectée, par l'entrée 5, afin de repousser les gouttes les unes des autres, et d'éviter toute coalescence lors de leur stockage.

Les sorties 4 et 6, en référence à la figure 1, sont connectées à des tubes qui peuvent être fermés, moyennant des vannes à pincement, qui sont commandées par un ordinateur. Initialement, la sortie 6 est fermée, et les gouttes s'écoulent le long du microcanal 1. Une fois que l'écoulement est permanent, la sortie 6 est ouverte, alors que la sortie 4 est fermée de manière simultanée. Des centaines de gouttes sont alors immobilisées dans le microcanal 1.

La température de la plaquette est commandée en utilisant un module Peltier (MELCOR, Taille 62x62 mm²) et une circulation d'eau à partir d'un cryostat, tous deux placés immédiatement en dessous de la plaquette. La seringue contenant la solution aqueuse et le tube de liaison correspondant sont chauffés au-dessus de la température de solubilité de la solution avec des dispositifs chauffants flexibles (Minco) pour éviter toute cristallisation intempestive. Quatre thermocouples (Thermocoax), qui sont insérés à travers la couche de PDMS jusqu'à la plaque de silicium, prennent des mesures de la température à proximité du microcanal 1. La grande taille du Peltier donne un champ de température uniforme le long de la zone de stockage, avec des différences inférieures à 0,1°C.

Les images de l'occurrence de la cristallisation dans les gouttes sont prises, en utilisant une binoculaire et une caméra CCD. La détection du nombre de cristaux est facilement enregistrée, grâce à la biréfringence des cristaux de KNO₃, qui apparaissent comme des pixels brillants, sous l'effet de polariseurs croisés. Au grandissement utilisé, la taille détectable des cristaux est d'environ 500 µm.

## Revendications

1. Procédé de suivi de la cristallisation d'une substance en solution dans un solvant, comprenant les étapes suivantes :
- on forme des gouttes (G) de ladite solution, éventuellement à différentes concentrations de ladite substance, dans une phase inerte (T) ;
- on produit et on stocke les gouttes dans au moins un microcanal de stockage (1) ;
- on forme des cristaux dans toutes les gouttes en refroidissant ces gouttes au-dessous de la température de solubilité de ladite substance ;
- on augmente la température afin d'induire la dissolution d'au moins une partie des cristaux dans au moins certaines gouttes ;
- on observe le processus de cristallisation et de dissolution par l'intermédiaire de moyens d'analyse.

2. Procédé selon la revendication 1, **caractérisé en ce qu'**on forme les gouttes à une température supérieure à la température de solubilité de ladite substance.

3. Procédé selon la revendication 1 ou 2, **caractérisé en ce que** le processus de cristallisation et de dissolution est observé par l'intermédiaire des moyens d'analyse de manière à déterminer le nombre de cristaux dans les gouttes.

4. Procédé selon l'une quelconque des revendications précédentes, comprenant une étape supplémentaire d'observation de la structure des cristaux formés pendant la cristallisation, notamment par spectroscopie Raman.

5. Procédé selon l'une quelconque des revendications précédentes, comprenant l'observation d'au moins deux structures cristallines différentes pour la même substance, en vue de la détermination du polymorphisme.

6. Procédé selon l'une quelconque des revendications précédentes, **caractérisé en ce que** le volume de chaque goutte formée est suffisamment petit pour induire un mécanisme de cristallisation mononucléaire, dans au moins une majorité des gouttes.

7. Procédé selon l'une quelconque des revendications précédentes, dans lequel on mesure la solubilité en fonction de la température d'un polymorphe métastable ou de plusieurs polymorphes en même temps.

8. Procédé selon l'une quelconque des revendications précédentes, **caractérisé en ce qu'**on identifie une première température (Tₘᵢₙ), pour laquelle tous les cristaux sont formés.

9. Procédé selon la revendication 8, **caractérisé en ce qu'**on fait descendre la température par paliers, on dénombre les cristaux pour différentes valeurs de température, et on détermine ladite première température (Tₘᵢₙ) comme étant la température au-dessous de laquelle aucun cristal supplémentaire n'est formé.

10. Procédé selon l'une quelconque des revendications précédentes, **caractérisé en ce qu'**on identifie une seconde température (Tₘₐₓ), pour laquelle tous les cristaux sont dissous.

11. Procédé selon la revendication 10, **caractérisé en ce qu'**on augmente la température par paliers, on dénombre les cristaux pour des valeurs de température de plus en plus élevées, et on identifie ladite seconde température (Tₘₐₓ) comme étant la température au-dessus de laquelle aucun cristal supplémentaire n'est dissous.

12. Procédé de criblage de plusieurs substances, dans lequel on prépare lesdites plusieurs substances, on réalise un suivi de la cristallisation de chaque substance selon le procédé conforme à l'une quelconque des revendications 1 à 11, et on identifie au moins une substance préférée, parmi lesdites plusieurs substances.

13. Procédé selon la revendication 12, dans lequel on prépare lesdites plusieurs substances en modifiant au moins un paramètre de ces substances, choisi notamment parmi le pH, la présence d'impuretés, ou encore la présence d'au moins un adjuvant.

14. Procédé selon la revendication 12 ou 13, **caractérisé en ce que** lesdites plusieurs substances sont formées d'un mélange d'au moins deux composants, et on prépare lesdites substances différentes en modifiant la proportion de ces composants.

## Patentansprüche

1. Verfahren zur Nachverfolgung der Kristallisation eines Stoffes in Lösung, folgende Schritte umfassend:
- Bilden von Tropfen (G) der Lösung, gegebenenfalls bei unterschiedlichen Konzentrationen des Stoffes, in einer inerten Phase (T);
- Erzeugen und Speichern der Tropfen in mindestens einem Speichermikrokanal (1);
- Bilden von Kristallen in allen Tropfen, indem diese Tropfen unter die Löslichkeitstemperatur des Stoffes gekühlt werden;
- Erhöhen der Temperatur, um das Lösen von mindestens einem Teil der Kristalle in mindestens gewissen Tropfen zu induzieren;
- Beobachten des Prozesses der Kristallisation und der Lösung über Analysemittel.

2. Verfahren nach Anspruch 1, **dadurch gekennzeichnet, dass** die Tropfen bei einer Temperatur größer als die Temperatur der Löslichkeit des Stoffes gebildet werden.

3. Verfahren nach Anspruch 1 oder 2, **dadurch gekennzeichnet, dass** der Prozess der Kristallisation und der Lösung über Analysemittel beobachtet wird, um die Anzahl der Kristalle in den Tropfen zu bestimmen.

4. Verfahren nach einem beliebigen der vorhergehenden Ansprüche, einen zusätzlichen Schritt des Beobachtens der Struktur der während der Kristallisation gebildeten Kristalle, insbesondere durch Raman-Spektrographie, umfassend.

5. Verfahren nach einem beliebigen der vorhergehenden Ansprüche die Beobachtung von mindestens zwei unterschiedlichen kristallinen Strukturen für denselben Stoff in Hinblick auf die Bestimmung des Polymorphismus umfassend.

6. Verfahren nach einem beliebigen der vorhergehenden Ansprüche,
**dadurch gekennzeichnet, dass** das Volumen jedes gebildeten Tropfens ausreichend klein ist, um einen mononuklearen Kristallisationsmechanismus in mindestens einer Mehrzahl von Tropfen zu induzieren.

7. Verfahren nach einem beliebigen der vorhergehenden Ansprüche, bei dem die Löslichkeit abhängig von der Temperatur eines metastabilen Polymorphs oder von mehreren Polymorphen zur selben Zeit gemessen wird.

8. Verfahren nach einem beliebigen der vorhergehenden Ansprüche,
**dadurch gekennzeichnet, dass** eine erste Temperatur (Tₘᵢₙ), für die alle Kristalle gebildet werden, identifiziert wird.

9. Verfahren nach Anspruch 8, **dadurch gekennzeichnet, dass** die Temperatur stufenweise abgesenkt wird, die Kristalle für unterschiedliche Temperaturwerte gezählt werden und die erste Temperatur (Tₘᵢₙ) als die Temperatur bestimmt wird, unter der kein zusätzliches Kristall gebildet wird.

10. Verfahren nach einem beliebigen der vorhergehenden Ansprüche,
**dadurch gekennzeichnet, dass** eine zweite Temperatur (Tₘₐₓ) identifiziert wird, für die alle Kristalle gelöst sind.

11. Verfahren nach Anspruch 10, **dadurch gekennzeichnet, dass** die Temperatur stufenweise erhöht wird, die Kristalle bei nacheinander ansteigenden Temperaturwerten gezählt werden und die zweite Temperatur (Tₘₐₓ) als die Temperatur identifiziert wird, über der kein zusätzliches Kristall gelöst wird.

12. Verfahren zum Sieben von mehreren Stoffen, bei dem die mehreren Stoffe zubereitet werden, eine Nachverfolgung der Kristallisation jedes Stoffs nach dem Verfahren nach einem beliebigen der Ansprüche 1 bis 11 realisiert wird und mindestens ein bevorzugter Stoff aus den mehreren Stoffen identifiziert wird.

13. Verfahren nach Anspruch 12, bei dem die mehreren Stoffe zubereitet werden, indem mindestens ein Parameter dieser Stoffe, ausgewählt insbesondere aus dem pH-Wert, dem Vorhandensein von Verunreinigungen oder auch dem Vorhandensein von mindestens einem Zusatzmittel, modifiziert wird.

14. Verfahren nach Anspruch 12 oder 13, **dadurch gekennzeichnet, dass** die mehreren Stoffe aus einer Mischung von mindestens zwei Inhaltsstoffen gebildet werden und die unterschiedlichen Stoffe durch Modifizieren des Mengenanteils dieser Inhaltsstoffe zubereitet werden.

## Claims

1. A method of following the crystallization of a substance in solution in a solvent, comprising the following steps:
- droplets (G) of said solution, optionally with different concentrations of said substance, are formed in an inert phase (T);
- the droplets are produced and stored in at least one storage microchannel (1);
- crystals are formed in all the droplets by cooling these droplets below the solubility temperature of said substance;
- the temperature is increased so as to dissolve at least some of the crystals in at least some droplets; and
- the crystallization and dissolution process is observed by analyzing means.

2. The method as claimed in claim 1, **characterized in that** the droplets are formed at a temperature above the solubility temperature of said substance.

3. The method as claimed in claim 1 or 2, **characterized in that** the crystallization and dissolution process is observed by the analyzing means so as to determine the number of crystals in the droplets.

4. The method as claimed in any one of the preceding claims, which includes an additional step of observing the structure of the crystals formed during the crystallization, especially by Raman spectroscopy.

5. The method as claimed in any one of the preceding claims, which includes the observation of at least two different crystalline structures for the same substance, because of the polymorphism determination.

6. The method as claimed in any one of the preceding claims, **characterized in that** the volume of each droplet formed is small enough to induce a single-nucleation crystallization mechanism in at least most of the droplets.

7. The method as claimed in any one of the preceding claims, in which the solubility is measured as a function of the temperature of a metastable polymorph or of several polymorphs at the same time.

8. The method as claimed in any one of the preceding claims, **characterized in that** a first temperature (Tₘᵢₙ), for which all the crystals are formed, is identified.

9. The method as claimed in claim 8, **characterized in that** the temperature is lowered in steps, the number of crystals for different temperature values is counted and said first temperature (Tₘᵢₙ) is determined as being the temperature below which no additional crystal is formed.

10. The method as claimed in any one of the preceding claims, **characterized in that** a second temperature (Tₘₐₓ), for which all the crystals are dissolved, is identified.

11. The method as claimed in claim 10, **characterized in that** the temperature is increased in steps, the number of crystals for increasingly higher temperatures is counted and said second temperature (Tₘₐₓ) is identified, this being the temperature above which no additional crystal dissolves.

12. A method of screening several substances, in which said several substances are prepared, the crystallization of each substance is followed using the method according to any one of claims 1 to 11, and at least one preferred substance, among said several substances, is identified.

13. The method as claimed in claim 12, in which said several substances are prepared by modifying at least one parameter of these substances, chosen in particular from the pH, the presence of impurities or the presence of at least one adjuvant.

14. The method as claimed in claim 12 or 13, **characterized in that** said several substances are formed from a mixture of at least two components and said different substances are prepared by modifying the proportion of these components.
